# EUROPEAN PATENT APPLICATION

(11) **EP 2 490 335 A2**
(43) Date of publication of application: **22.08.2012**
(21) Application number: 12155424.0
(22) Date of filing: 14.02.2012
(51) Int. Cl.: H03K 17/16

(54) **Semiconductor device**

(30) Priority: 15.02.2011 JP 2011030132
(71) Applicant: Kabushiki Kaisha Toshiba, Minato-ku Tokyo 105-8001 (JP)
(72) Inventor: Takimoto, Kazuyasu, TOKYO, Tokyo 105-8001 (JP); Mochikawa, Hiroshi, TOKYO, Tokyo 105-8001 (JP); Nakazawa, Yosuke, TOKYO, Tokyo 105-8001 (JP); Kuzumaki, Atsuhiko, TOKYO, Tokyo 105-8001 (JP)
(74) Representative: Fritsche, Daniel

(57) **Abstract**

According to one embodiment, a semiconductor device (D) includes a semiconductor circuit (22) and an electric-power supply (9). The semiconductor circuit includes a main element (3) including a switching element (1) and an antiparallel diode (2), a reverse voltage application circuit (7) including a high-speed free wheeling diode (4), a capacitor (6) and an auxiliary element (5), a main element drive circuit (13), and an auxiliary element drive circuit (14). The electric-power supply is configured to supply electric-power to the capacitor, the main element drive circuit and the auxiliary element drive circuit, and has a voltage lower than the withstand voltage of the main element.

## Description

### FIELD

Embodiments described herein relate generally to a semiconductor device.

### BACKGROUND

In recent years, development of techniques associated with various electric-power converters is being advanced. For example, when an electric-power converter includes an inverter circuit, the inverter circuit is constituted of a plurality of semiconductor switches. Each of the semiconductor switches applies an electric-power switching element. The main element of the semiconductor switch includes a switching element for electric-power, and antiparallel diode connected in anti-parallel with the switching element. Development of a technique for improving the reverse recovery characteristics of the antiparallel diode is also being advanced.

The semiconductor switch includes a reverse voltage application circuit in addition to the main element. The reverse voltage application circuit is configured to apply a reverse voltage lower than the withstand voltage of the main element to the antiparallel diode, and constitutes one arm of a bridge circuit.

The reverse voltage application circuit is provided with an auxiliary electric-power supply having a voltage lower than the withstand voltage of the main element, auxiliary element which is turned on at the time of reverse recovery of the antiparallel diode, and has a withstand voltage lower than the main element, high-speed free wheeling diode having a reverse recovery time of which is shorter than the antiparallel diode, and a reverse recovery charge of which is smaller than the antiparallel diode, and capacitor connected in parallel with the auxiliary electric-power supply. The auxiliary electric-power supply, auxiliary element, and high-speed free wheeling diode constitute a series connection.

The auxiliary element is turned on during a dead time, whereby a main current is commutated from the antiparallel diode to the high-speed free wheeling diode by a supply of energy from the capacitor charged by the auxiliary electric-power supply. In the state where the high-speed free wheeling diode performs return current operation, an on-signal is input to a control terminal of the main element of the opposite arm, and hence the high-speed free wheeling diode causes reverse recovery in place of the antiparallel diode. Accordingly, it becomes possible to more significantly reduce the surge current resulting from the reverse recovery than the conventional method.

### BRIEF DESCRIPTION OF THE DRAWINGS

FIG. 1 is a circuit diagram showing an electric-power converter provided with a semiconductor device according to a first embodiment.
FIG. 2 is a circuit diagram showing the semiconductor device according to the first embodiment.
FIG. 3 is a circuit diagram showing a semiconductor device according to a second embodiment.
FIG. 4 is a circuit diagram showing a semiconductor device according to a third embodiment.
FIG. 5 is a circuit diagram showing a semiconductor device according to a fourth embodiment.
FIG. 6 is a circuit diagram showing a semiconductor device according to a fifth embodiment.
FIG. 7 is a circuit diagram showing a semiconductor device according to a sixth embodiment.
FIG. 8 is a circuit diagram showing a semiconductor device according to a seventh embodiment.

### DETAILED DESCRIPTION

In general, according to one embodiment, there is provided a semiconductor device comprising a semiconductor circuit, and an electric-power supply. The semiconductor circuit comprises a main element including a voltage-drive-type switching element, and an antiparallel diode connected in anti-parallel with the switching element, a reverse voltage application circuit including a high-speed free wheeling diode having a reverse recovery time of which is shorter than the antiparallel diode, and a reverse recovery charge of which is smaller than the antiparallel diode, a capacitor, and an auxiliary element connected between the capacitor and the high-speed free wheeling diode, configured to be turned on at the time of reverse recovery of the antiparallel diode, and having a withstand voltage of which is lower than the main element, and configured to apply a reverse voltage lower than the withstand voltage of the main element to the antiparallel diode, a main element drive circuit configured to supply a control signal to the main element, and an auxiliary element drive circuit configured to supply a control signal to the auxiliary element. The electric-power supply is connected in parallel with the capacitor, is further connected to the main element drive circuit, and the auxiliary element drive circuit, is configured to supply electric-power to the capacitor, the main element drive circuit and the auxiliary element drive circuit, and has a voltage lower than the withstand voltage of the main element.

Hereinafter, a semiconductor device according to a first embodiment will be described in detail by referring to the drawings. In this embodiment, an electric-power converter provided with a plurality of semiconductor devices will be described.

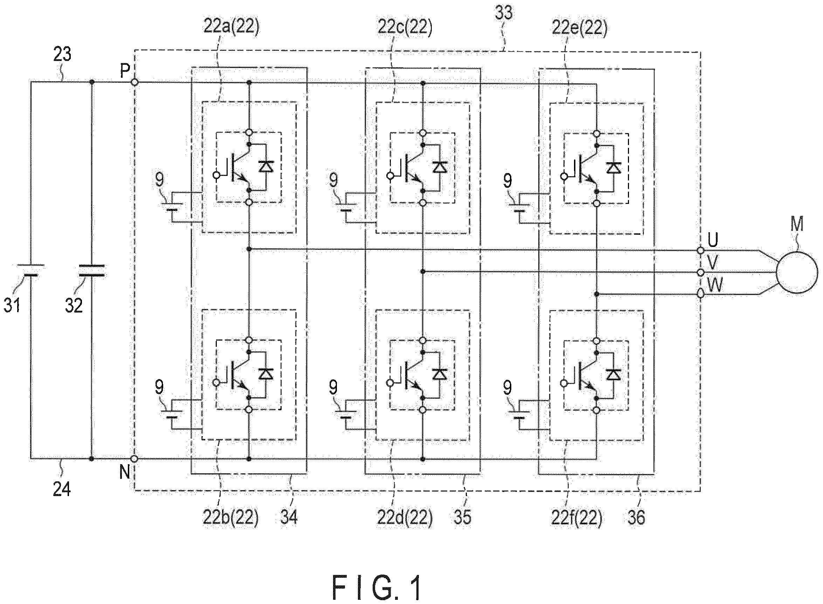

As shown in FIG. 1, the electric-power converter comprises a DC voltage source 31, smoothing capacitor 32, and a two-level inverter circuit 33 serving as an inverter circuit. The two-level inverter circuit 33 is connected to a cooling unit (not shown) to thereby be cooled.

The DC voltage source 31 is obtained by rectifying a three-phase AC electric-power supply. The capacitor 32 and two-level inverter circuit 33 are connected between a positive side DC bus line 23 and negative side DC bus line 24 of the DC voltage source 31. The two-level inverter circuit 33 is constituted of three semiconductor circuit groups 34, 35, and 36, and electric-power supplies (auxiliary electric-power supplies) 9. The semiconductor circuit groups 34, 35, and 36 are connected in parallel with each other.

The semiconductor circuit group 34 includes a first semiconductor circuit 22a, and second semiconductor circuit 22b which are connected in series between a terminal P of the positive potential side, and terminal N of the negative potential side. The semiconductor circuit group 35 includes a first semiconductor circuit 22c, and second semiconductor circuit 22d which are connected in series between the terminal P of the positive potential side, and terminal N of the negative potential side. The semiconductor circuit group 36 includes a first semiconductor circuit 22e, and second semiconductor circuit 22f which are connected in series between the terminal P of the positive potential side, and terminal N of the negative potential side. An electric-power supply 9 is connected to each of the semiconductor circuits 22 (22a to 22f).

The two-level inverter circuit 33 is configured to convert DC electric-power input from the terminal P of the positive potential side, and terminal N of the negative potential side into AC electric-power to thereby supply the AC electric-power to a load M from output terminals U, V, and W.

Next, a semiconductor device D provided with the semiconductor circuit 22 (22a to 22f), and electric-power supply 9 will be described below.

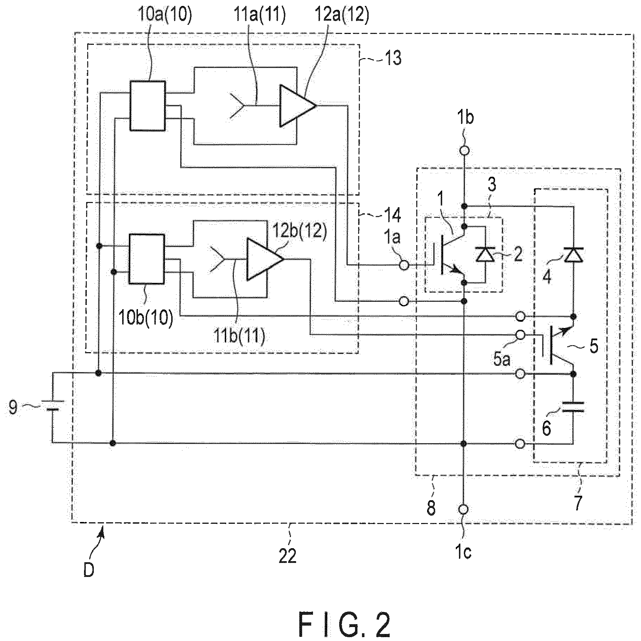

As shown in FIG. 2, the semiconductor device D comprises the semiconductor circuit 22, and electric-power supply 9. The semiconductor circuit 22 comprises a semiconductor switch 8, main element drive circuit 13, and auxiliary element drive circuit 14. The semiconductor switch 8 comprises a main element 3, and reverse voltage application circuit 7.

The main element 3 includes a voltage-drive-type switching element 1, and antiparallel diode 2. The switching element 1 includes a control terminal 1a, positive terminal 1b, and negative terminal 1c. In this embodiment, the switching element 1 is constituted of an insulated gate bipolar transistor (IGBT). In the switching element 1, a control signal is supplied to the control terminal 1a, thereby switching the element 1 to a conductive state or a non-conductive state. In the switching element 1, the control signal (gate signal) is supplied to the control terminal 1a (gate) from the main element drive circuit 13, whereby the element 1 is switched to the conductive state (on) or the non-conductive state (off).

The antiparallel diode 2 is connected in antiparallel with the switching element 1.

The reverse voltage application circuit 7 includes a high-speed free wheeling diode 4, auxiliary element 5, and capacitor 6.

The negative electrode side of the high-speed free wheeling diode 4 is electrically connected to the positive terminal 1b. The high-speed free wheeling diode has a reverse recovery time shorter than the antiparallel diode 2, and reverse recovery charge smaller than the antiparallel diode 2.

The capacitor 6 is a capacitor for reverse voltage application, and one electrode thereof is connected to the negative terminal 1c.

The auxiliary element 5 is connected between the other electrode of the capacitor 6, and the positive electrode side of the high-speed free wheeling diode 4. It should be noted that the high-speed free wheeling diode 4, auxiliary element 5, and capacitor 6 are connected in series. The auxiliary element 5 includes a control terminal 5a, and a control signal is supplied to the control terminal 5a, thereby switching the element 5 to the conductive state or the non-conductive state. For example, in the auxiliary element 5, the control signal (gate signal) is supplied to the control terminal 5a (gate) from the auxiliary element drive circuit 14, whereby the element 5 is switched on or off. The auxiliary element 5 is turned on at the time of reverse recovery of the antiparallel diode 2, and has a withstand voltage lower than the main element 3.

The reverse voltage application circuit 7 is capable of applying a reverse voltage lower than the withstand voltage of the main element 3 to the antiparallel diode 2.

The main element drive circuit 13 includes an insulated DC-DC converter 10a, and voltage amplifier circuit 12a. The insulated DC-DC converter 10a is connected to two terminals of the voltage amplifier circuit 12a, and supplies positive and negative source voltages to these two terminals. The insulated DC-DC converter 10a is also connected to the negative terminal 1c of the switching element 1.

An input control signal 11a is supplied to an input terminal of the voltage amplifier circuit 12a. An output terminal of the voltage amplifier circuit 12a is connected to the control terminal 1a. The main element drive circuit 13 (voltage amplifier circuit 12a) supplies a control signal to the main element 3 (control terminal 1a).

The auxiliary element drive circuit 14 includes an insulated DC-DC converter 10b, and voltage amplifier circuit 12b. The insulated DC-DC converter 10b is connected to two terminals of the voltage amplifier circuit 12b, and supplies positive and negative source voltages to these two terminals. The insulated DC-DC converter 10b is also connected to a terminal of the auxiliary element 5 of the high-speed free wheeling diode 4 side.

An input control signal 11b is supplied to an input terminal of the voltage amplifier circuit 12b. An output terminal of the voltage amplifier circuit 12b is connected to the control terminal 5a. The auxiliary element drive circuit 14 (voltage amplifier circuit 12b) supplies a control signal to the auxiliary element 5 (control terminal 5a).

The electric-power supply 9 is connected in parallel with the capacitor 6, and is connected to the main element drive circuit 13, and auxiliary element drive circuit 14. The electric-power supply 9 supplies the capacitor 6, main element drive circuit 13, and auxiliary element drive circuit 14 with electric electric-power. As described above, electric-power is supplied to the capacitor 6, main element drive circuit 13, and auxiliary element drive circuit 14 from one electric-power supply 9. The voltage of the electric-power supply 9 is lower than the withstand voltage of the main element 3.

Further, in the above example, although the configuration is set in such a manner that the voltage of the capacitor 6 is the voltage of the electric-power supply 9, and the voltage is insulated by the insulated DC-DC converters 10 (10a, 10b) to thereby be transmitted to the main element drive circuit 13, and auxiliary element drive circuit 14, the voltage of the electric-power supply 9 may be used as the drive voltage of the main element drive circuit 13 or the auxiliary element drive circuit 14.

The electric-power conversion device including the semiconductor devices D, and the like is constituted in the manner described above.

As shown in FIG. 1 and FIG. 2, paying attention to the semiconductor circuit group 34, there is a dead time during which the switching element 1 of each of the first semiconductor circuit 22a and second semiconductor circuit 22b is off.

In the second semiconductor circuit 22b, the auxiliary element 5 is turned on during the dead time, whereby the main current is commutated from the antiparallel diode 2 to the high-speed free wheeling diode 4 by a supply of energy from the capacitor 6 charged by the electric-power supply 9. In the state where the high-speed free wheeling diode 4 performs return current operation, the switching element 1 of the first semiconductor circuit 22a is switched on, and hence the high-speed free wheeling diode 4 causes reverse recovery in place of the antiparallel diode 2. Accordingly, it becomes possible to greatly reduce the surge current resulting from the reverse recovery.

According to the electric-power conversion device provided with the semiconductor devices D according to the first embodiment, the semiconductor device D comprises the semiconductor circuit 22, and electric-power supply 9. The semiconductor circuit 22 comprises the main element 3 including the switching element 1 and antiparallel diode 2, reverse voltage application circuit 7 including the high-speed free wheeling diode 4, capacitor 6 and auxiliary element 5, main element drive circuit 13, and auxiliary element drive circuit 14.

The electric-power supply 9 is connected in parallel with the capacitor 6, is further connected to the main element drive circuit 13 and auxiliary element drive circuit 14, supplies the capacitor 6, main element drive circuit 13, and auxiliary element drive circuit 14 with electric-power, and has a voltage lower than the withstand voltage of the main element 3. The high-speed free wheeling diode 4 causes reverse recovery in place of the antiparallel diode 2, and hence it is possible to greatly reduce the surge current resulting from the reverse recovery.

The electric-power supply 9 can be used in common as the electric-power supplies used to supply electric-power to the capacitor 6, main element drive circuit 13, and auxiliary element drive circuit 14. That is, it is not necessary to separately attach an electric-power supply to each of the capacitor 6, main element drive circuit 13, and auxiliary element drive circuit 14, and hence it is possible to make the semiconductor device D smaller and, consequently, make the electric-power conversion device smaller.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a second embodiment will be described below. It should be noted that in this embodiment, the other configurations are identical to the first embodiment described above, and parts identical to those of the first embodiment are denoted by reference symbols identical to those of the first embodiment, and a detailed description of them is omitted.

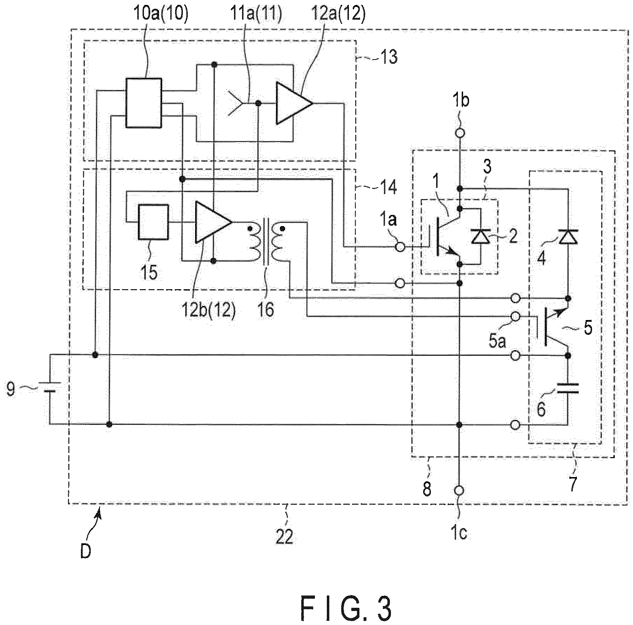

As shown in FIG. 3, an auxiliary element drive circuit 14 includes a voltage amplifier circuit 12b, logic circuit 15, and pulse transformer 16. An insulated DC-DC converter 10a is connected to two terminals of the voltage amplifier circuit 12b, and supplies positive and negative source voltages to these two terminals. An input control signal 11a is supplied to an input terminal of the voltage amplifier circuit 12b through the logic circuit 15.

The pulse transformer 16 includes an insulated primary circuit and secondary circuit. The primary circuit of the pulse transformer 16 is connected to an output terminal of the voltage amplifier circuit 12b, and the insulated DC-DC converter 10a. The secondary circuit of the pulse transformer 16 is connected to a control terminal 5a, and terminal of an auxiliary element 5 of the high-speed free wheeling diode 4 side. The auxiliary element drive circuit 14 (pulse transformer 16) supplies a control signal to an auxiliary element 5 (control terminal 5a).

As described above, an electric-power supply 9 is connected to the auxiliary element drive circuit 14 through the main element drive circuit 13, and supplies electric-power to the circuit 14 through the circuit 13. The auxiliary element drive circuit 14 includes the pulse transformer 16, and can supply a control signal to the auxiliary element 5 in a state where the insulation of the auxiliary element 5 from the main element drive circuit 13 is held.

According to the electric-power conversion device provided with the semiconductor devices D according to the second embodiment configured as described above, the semiconductor device D comprises the semiconductor circuit 22, and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuit 22 can be carried out by one electric-power supply 9, and hence it is possible to make the semiconductor device D smaller and, consequently, make the electric-power conversion device smaller.

The insulated DC-DC converter 10a can be used in common for the main element drive circuit 13 and auxiliary element drive circuit 14. The insulated DC-DC converter is large and expensive, and hence it is possible to reduce the size and manufacturing cost corresponding to the insulated DC-DC converter 10b as compared with the first embodiment.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a third embodiment will be described below. It should be noted that in this embodiment, the other configurations are identical to the first embodiment described previously, and parts identical to those of the first embodiment are denoted by reference symbols identical to those of the first embodiment, and a detailed description of them is omitted.

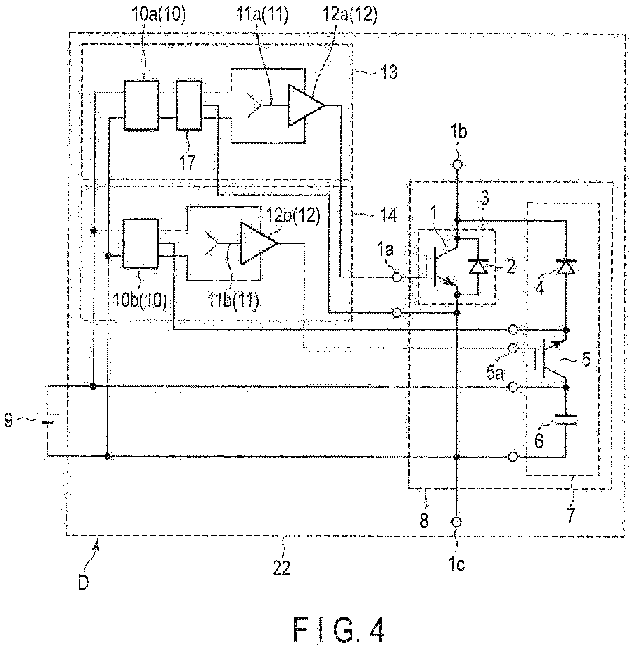

As shown in FIG. 4, a semiconductor device D further comprises a regulator 17 configured to keep at least one of the voltage across a capacitor 6, the drive voltage of a main element drive circuit 13, and the drive voltage of an auxiliary element drive circuit 14 constant. In this embodiment, the regulator 17 is provided in the main element drive circuit 13, and is capable of keeping the drive voltage of the main element drive circuit 13 constant.

Needless to say, the semiconductor device D can be provided with a regulator configured to keep the voltage across the capacitor 6 constant or a regulator configured to keep the drive voltage of the auxiliary element drive circuit 14 constant.

According to the electric-power conversion device provided with the semiconductor devices D according to the third embodiment configured as described above, the semiconductor device D comprises the semiconductor circuit 22 and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuit 22 can be carried out by one electric-power supply 9, and hence it is possible to make the semiconductor device D smaller and, consequently, make the electric-power conversion device smaller.

The regulator 17 can keep the drive voltage of the main element drive circuit 13 constant, and hence stable operation of the main element drive circuit 13 (semiconductor circuit 22) can be obtained. Needless to say, by being provided with a regulator configured to keep the voltage across the capacitor 6 constant or a regulator configured to keep the drive voltage of the auxiliary element drive circuit 14 constant as the need arises, it is possible for the semiconductor device D to obtain stable operation of the capacitor 6 or the auxiliary element drive circuit 14.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a fourth embodiment will be described below. It should be noted that in this embodiment, the other configurations are identical to the first embodiment described previously, and parts identical to those of the first embodiment are denoted by reference symbols identical to those of the first embodiment, and a detailed description of them is omitted.

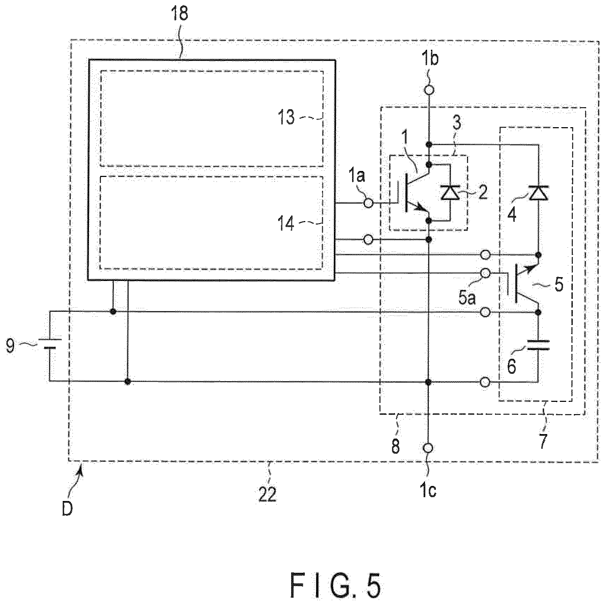

As shown in FIG. 5, a semiconductor device D is further provided with a board 18 on which a main element drive circuit 13, and auxiliary element drive circuit 14 are mounted.

According to the electric-power conversion device provided with the semiconductor devices D according to the fourth embodiment configured as described above, the semiconductor device D comprises the semiconductor circuit 22, and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuit 22 can be carried out by one electric-power supply 9, and hence it is possible to make the semiconductor device D smaller and, consequently, make the electric-power conversion device smaller.

The main element drive circuit 13 and auxiliary element drive circuit 14 are mounted on the same board 18. Accordingly, it is possible to make the semiconductor device D smaller and, consequently, make the electric-power conversion device smaller.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a fifth embodiment will be described below. It should be noted that in this embodiment, the other configurations are identical to the first embodiment described previously, and parts identical to those of the first embodiment are denoted by reference symbols identical to those of the first embodiment, and a detailed description of them is omitted.

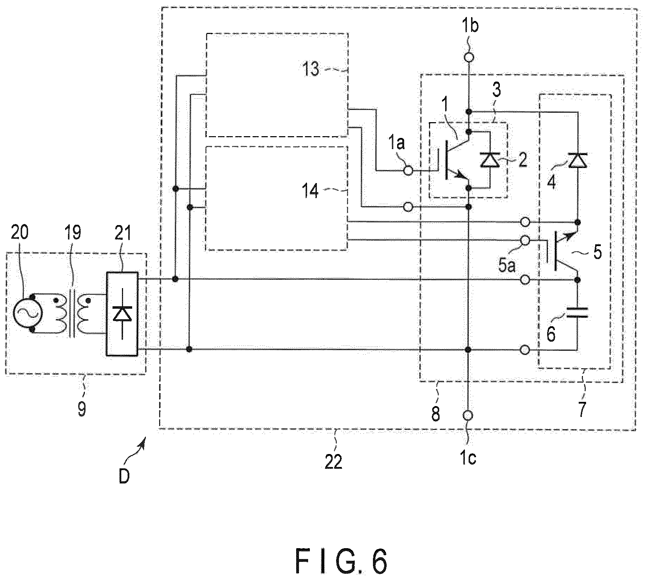

As shown in FIG. 6, an electric-power supply 9 includes an electric-power supply source 20, insulating transformer 19 and rectifier circuit 21. The insulating transformer 19 includes a primary circuit connected to the electric-power supply source 20, and secondary circuit connected to a semiconductor circuit 22 through the rectifier circuit 21, and insulates the primary circuit and secondary circuit from each other. The primary circuit and secondary circuit are configured to insulate to each other.

According to the electric-power conversion device provided with the semiconductor devices D according to the fifth embodiment configured as described above, the semiconductor device D comprises the semiconductor circuit 22, and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuit 22 can be carried out by one electric-power supply 9, and hence it is possible to make the semiconductor device D smaller and, consequently, make the electric-power conversion device smaller. Further, it is possible to realize the electric-power supply 9 of each of the semiconductor devices D according to the first to fourth embodiments described above in the manner described above.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a sixth embodiment will be described below. It should be noted that in this embodiment, the other configurations are identical to the fifth embodiment described above, and parts identical to those of the fifth embodiment are denoted by reference symbols identical to those of the fifth embodiment, and a detailed description of them is omitted.

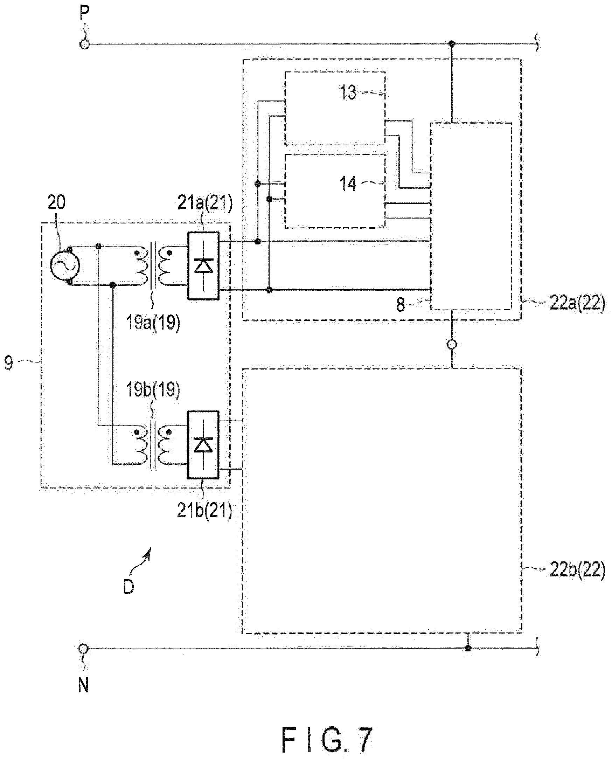

As shown in FIG. 7, a semiconductor device D further comprises at least one or more other semiconductor circuits configured in the same manner as the semiconductor circuit 22. In this embodiment, the semiconductor device D comprises a semiconductor circuit 22a (22), semiconductor circuit 22b (22) configured in the same manner as the semiconductor circuit 22a, and electric-power supply 9.

The electric-power supply 9 further comprises at least one or more other insulating transformers 19. At least one or more the other insulating transformers 19 include at least one or more other primary circuits connected to the electric-power supply source 20 with each other, and at least one or more other secondary circuits connected to aforementioned at least one or more the other semiconductor circuits 22 on a one-to-one basis, and insulate the other primary circuits, and the other secondary circuits corresponding to each other on a one-to-one basis from each other.

In this embodiment, the electric-power supply 9 includes the electric-power supply source 20, the insulating transformer 19a (19) serving as an insulating transformer, insulating transformer 19b (19) serving as the other insulating transformer, rectifier circuit 21a, and rectifier circuit 21b.

The insulating transformer 19a includes a primary circuit connected to the electric-power supply source 20, and secondary circuit connected to the semiconductor circuit 22a through the rectifier circuit 21a, and insulates the primary circuit and secondary circuit from each other.

The insulating transformer 19b includes a primary circuit connected to the electric-power supply source 20, and secondary circuit connected to the semiconductor circuit 22b through the rectifier circuit 21b, and insulates the primary circuit and secondary circuit from each other.

According to the electric-power conversion device provided with the semiconductor devices D according to the sixth embodiment configured as described above, the semiconductor device D comprises the semiconductor circuits 22 and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuits 22 can be carried out by one electric-power supply 9, and hence it is possible to make the semiconductor device D smaller and, consequently, make the electric-power conversion device smaller.

Further, the electric-power supply source 20 can be used in common as both an electric-power supply source for the semiconductor circuit 22a, and electric-power supply source for the semiconductor circuit 22b, and the space for electric-power supply for one semiconductor circuit 22 occupied by the electric-power supply source 20 can be reduced, and hence it is possible to make the semiconductor device D smaller and, consequently, make the electric-power conversion device smaller.

From the above description, it is possible to obtain a semiconductor device D in which the reverse recovery characteristics of the antiparallel diode 2 of the main element 3 can be improved, and which can be made smaller, and electric-power conversion device provided with the semiconductor devices D.

Next, an electric-power conversion device provided with a semiconductor device according to a seventh embodiment will be described below. It should be noted that in this embodiment, the other configurations are identical to the fifth embodiment described above, and parts identical to those of the fifth embodiment are denoted by reference symbols identical to those of the fifth embodiment, and a detailed description of them is omitted.

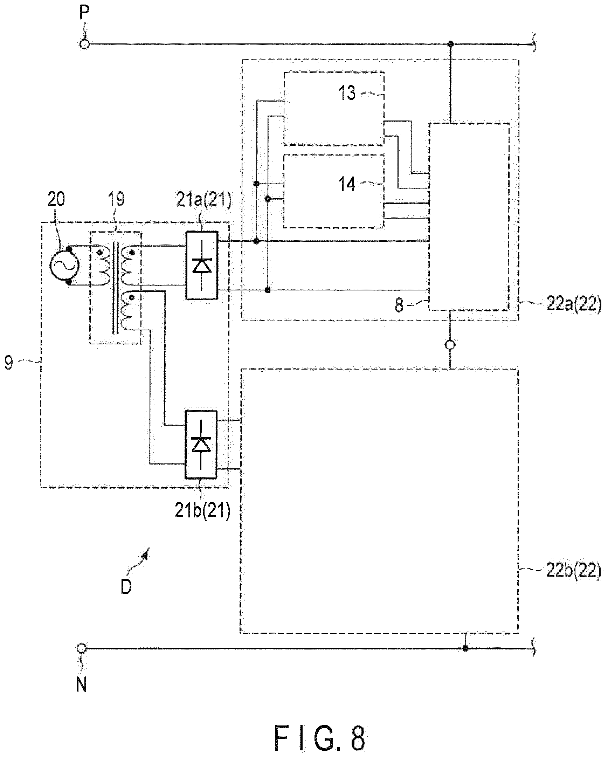

As shown in FIG. 8, the semiconductor device D further comprises at least one or more other semiconductor circuits configured in the same manner as the semiconductor circuit 22. In this embodiment, the semiconductor device D comprises a semiconductor circuit 22a (22), semiconductor circuit 22b (22) configured in the same manner as the semiconductor circuit 22a, and serving as the other semiconductor circuit, and electric-power supply 9.

An insulating transformer 19 further includes at least one or more other secondary circuits connected to at least one or more the other semiconductor circuits on a one-to-one basis. The insulating transformer 19 insulates the primary circuit, and secondary circuit and at least one or more the other secondary circuits from each other.

In this embodiment, the insulating transformer 19 further includes the other secondary circuit connected to the semiconductor circuit 22b on a one-to-one basis.

In this embodiment, the electric-power supply 9 includes electric-power supply source 20, insulating transformer 19, rectifier circuit 21a and rectifier circuit 21b. The secondary circuit of the insulating transformer 19 is connected to the semiconductor circuit 22a through the rectifier circuit 21a, and the other secondary circuit of the insulating transformer 19 is connected to the semiconductor circuit 22b through the rectifier circuit 21b. The insulating transformer 19 insulates the primary circuit, and secondary circuit and other secondary circuit from each other.

According to the electric-power conversion device provided with the semiconductor devices D according to the seventh embodiment configured as described above, the semiconductor device D comprises the semiconductor circuits 22 and electric-power supply 9. Accordingly, as in the case of the first embodiment, the high-speed free wheeling diode 4 causes reverse recovery in place of the antiparallel diode 2, and hence it is possible to greatly reduce the surge current resulting from the reverse recovery. Further, functions of electric-power supplies for the semiconductor circuits 22 can be carried out by one electric-power supply 9, and hence it is possible to make the semiconductor device D smaller and, consequently, make the electric-power conversion device smaller.

Further, the electric-power supply source 20 can be used in common as both an electric-power supply source for the semiconductor circuit 22a, and electric-power supply source for the semiconductor circuit 22b, and the space for electric-power supply for one semiconductor circuit 22 occupied by the electric-power supply source 20 can be reduced, and hence it is possible to make the semiconductor device D smaller and, consquently, make the electric-power conversion device smaller.

The electric-power supply 9 includes the insulating transformer 19 obtained by integrating the insulating transformer 19a, and insulating transformer 19b according to the aforementioned sixth embodiment into one insulating transformer, and hence it is possible to make the semiconductor device D smaller and, consequently, make the electric-power conversion device smaller.

From the above description, it is possible to obtain a semiconductor device D in which the reverse recovery characteristics of the antiparallel diode 2 of the main element 3 can be improved, and which can be made smaller, and a electric-power conversion device provided with the semiconductor devices D.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

For example, the above-mentioned semiconductor device can be utilized for various electric-power conversion devices and other electronic devices without being limited to the above-mentioned electric-power conversion device.

## Claims

1. A semiconductor device (D) comprising:
a semiconductor circuit (22); and
an electric-power supply (9), **characterized in that**
the semiconductor circuit comprises
a main element (3) including a voltage-drive-type switching element (1), and an antiparallel diode (2) connected in anti-parallel with the switching element,
a reverse voltage application circuit (7) including a high-speed free wheeling diode (4) having a reverse recovery time of which is shorter than the antiparallel diode, and a reverse recovery charge of which is smaller than the antiparallel diode, a capacitor (6), and an auxiliary element (5) connected between the capacitor and the high-speed free wheeling diode, configured to be turned on at the time of reverse recovery of the antiparallel diode, and having a withstand voltage of which is lower than the main element, and configured to apply a reverse voltage lower than the withstand voltage of the main element to the antiparallel diode,
a main element drive circuit (13) configured to supply a control signal to the main element, and
an auxiliary element drive circuit (14) configured to supply a control signal to the auxiliary element, and
the electric-power supply is connected in parallel with the capacitor, is further connected to the main element drive circuit, and the auxiliary element drive circuit, is configured to supply electric-power to the capacitor, the main element drive circuit and the auxiliary element drive circuit, and has a voltage lower than the withstand voltage of the main element.

2. The semiconductor device according to claim 1, **characterized in that**
the electric-power supply is connected to the auxiliary element drive circuit through the main element drive circuit, and configured to supply electric-power to the auxiliary element drive circuit through the main element drive circuit, and
the auxiliary element drive circuit comprises a pulse transformer (16), and is configured to supply the control signal to the auxiliary element in a state where insulation of the auxiliary element from the main element drive circuit is held.

3. The semiconductor device according to claim 1, **characterized by** further comprising a regulator (17) configured to keep at least one of a voltage across the capacitor, a drive voltage of the main element drive circuit, and a drive voltage of the auxiliary element drive circuit constant.

4. The semiconductor device according to claim 1, **characterized by** further comprising a board (18) on which the main element drive circuit and the auxiliary element drive circuit are mounted.

5. The semiconductor device according to claim 1, **characterized in that**
the electric-power supply comprises a electric-power supply source (20), and
an insulating transformer (19) including a primary circuit connected to the electric-power supply source and a secondary circuit connected to the semiconductor circuit, the primary circuit and the secondary circuit being configured to insulate to each other.

6. The semiconductor device according to claim 5, **characterized by** further comprising at least one or more other semiconductor circuits (22) configured in the same manner as the semiconductor circuit, **characterized in that**
the electric-power supply further comprises at least one or more other insulating transformers (19) including at least one or more other primary circuits connected to the electric-power supply source with each other, and at least one or more other secondary circuits connected to said at least one or more the other semiconductor circuits on a one-to-one basis, said at least one or more other primary circuits and said at least one or more other secondary circuits corresponding to each other on a one-to-one basis being configured to insulate to each other.

7. The semiconductor device according to claim 5, **characterized by** further comprising at least one or more other semiconductor circuits (22) configured in the same manner as the semiconductor circuit, **characterized in that**
the insulating transformer further includes at least one or more other secondary circuits connected to said at least one or more the other semiconductor circuits on a one-to-one basis, the primary circuit, and the secondary circuit and said at least one or more the other secondary circuits being configured to insulate to each other.
